# EUROPEAN PATENT SPECIFICATION

(11) **EP 2 971 248 B1**
(45) Date of publication and mention of the grant of the patent: **13.10.2021**
(21) Application number: 14769942.5
(22) Date of filing: 13.03.2014
(51) Int. Cl.: H01L 21/02, H01L 21/321

(54) **AQUEOUS CLEANING COMPOSITION FOR POST COPPER CHEMICAL MECHANICAL PLANARIZATION**
WÄSSRIGE REINIGUNGSZUSAMMENSETZUNG FÜR POST-CU-CMP
COMPOSITION AQUEUSE DE NETTOYAGE POUR UNE POST-PLANARISATION CHIMICO-MÉCANIQUE DE CUIVRE

(30) Priority: 15.03.2013 US 201361793073 P
(43) Date of publication of application: 20.01.2016
(73) Proprietor: CMC Materials, Inc., Aurora, IL 60504 (US)
(72) Inventor: KO, Cheng-Yuan, Aurora, Illinois 60504 (US)
(74) Representative: Barker Brettell LLP
(86) International application number: PCT/US2014/025563
(87) International publication number: WO 2014/151361

(56) References cited:
- EP-A1- 2 199 379
- US-A1- 2003 078 173
- US-A1- 2005 090 104
- US-A1- 2005 170 650
- US-A1- 2007 225 186
- US-A1- 2007 225 186
- US-A1- 2009 162 537
- US-A1- 2009 162 537
- US-A1- 2012 048 295
- US-A1- 2012 283 163
- US-B1- 7 919 446
- None

## Description

### FIELD OF THE INVENTION

The subject invention relates to an aqueous cleaning composition, particularly an aqueous cleaning composition for post copper chemical mechanical planarization (CMP) in the integrated circuit process.

### DESCRIPTIONS OF THE RELATED ART

Newer semiconductor devices have narrower wire widths and higher integration densities. However, while the minimal wire width is narrower than 0.25 µm or less, the resistance of the metal wire and the RC delay of the dielectric parasitic capacitance have slowed the operating speed of the device. To improve the operating speed of the device, copper wires have replaced conventional aluminum-copper alloy wires using an advanced process under 0.13 µm; the process is thereby called the "copper process."

Chemical mechanical planarization (CMP) combines an abrasive particle such as silica, alumina, ceria or zirconia and a chemical assistant such as a pH buffer or oxidant in an abrasive solution to polish a surface material. The higher region of the uneven surface will be under a higher pressure and thus, will be polished at a higher removal rate. At the same time, the lower region of the uneven surface will be under a lower pressure and thus, be polished at a lower removal rate. A global planarization is achieved. Applying the CMP technique to the copper wire process may solve the problem of defining patterns on a wafer due to the difficulty of etching copper, and may also form a plane with a global planarity after the abrasion, which contributes to a multilayer wire structuring process.

During the CMP process, the fine abrasive particles and chemical assistant in the abrasive solution and the cuttings generated from abrading the wafer may be attached onto the wafer surface. General contaminants generated after the abrasion of the wafer are metal ions, organic compounds, or abrasive particles. Without an effective cleaning procedure to remove the contaminants, the subsequent process is disrupted and the yield and reliability of the device will decrease. Therefore, the cleaning procedure after the CMP process has become key to whether the CMP process may be successfully applied in the semiconductor process field or not.

The abrasive solution for the copper process usually uses benzotriazole (BTA) or its derivative as a corrosion inhibitor. Among the contaminants generated after the abrasion of the copper process wafer, it is most difficult to remove BTA organic residuals. The main reason is that the BTA organic residuals bond to the copper wire through chemisorption. Conventionally, only physical manners, such as electrostatic repulsion, ultrasound sonication, and PVA brushing, are utilized to remove BTA, though not successfully.

Furthermore, an aqueous solution of ammonia, aqueous solution of citric acid and/or fluorine-containing compound are usually used to clean the inter-metal dielectric layer and W plug after the CMP process. However, the aqueous solution of ammonia corrodes the copper surface unevenly, thus, leading to roughening. In addition, the aqueous solution of citric acid has a weak solubility towards copper and thus, a slower rate of removing contaminants. The fluorine-containing compound such as hydrofluoric acid not only makes the copper surface rough, but also is costly to dispose of safely due to the harmful chemicals. Therefore, the cleaning solutions above are not suitable for cleaning wafers with a copper wire.

A solution of N-containing compound has been proposed to replace ammonia in the cleaning composition. US 6,492,308 by Naghshineh et al. discloses a cleaning solution for a copper-containing integrated circuit, comprising a C₁-C₁₀ quaternary ammonium hydroxide, a polar organic amine and a corrosion inhibitor, wherein the polar organic amine may be selected from ethanolamine. US2009/162537A1 by Kolic et al. discloses a method for cleaning a substrate with copper and a dielectric damascene metallization layer, comprising the use of a cleaning solution that has one or more amines such as alcohol amine, wherein at least one amine can provide a pH for the cleaning solution that ranges from 7 to 13. US 8,063,006 by Chen et al. discloses an aqueous cleaning composition for cleaning post CMP copper wafers in the integrated circuit process, comprising an N-containing heterocyclic organic base, alcohol amine, and water. However, the roughness on the surface of the wafer caused by the cleaning composition in the prior art needs to be improved. Especially for wafers with a copper wire, it is difficult to control the etching of the amine to metal, reduce the contaminants generated after abrading the wafers, and reduce the total defect counts on regions with different components on the wafers.

US 7 919 446 B1 discloses an aqueous cleaning composition for post-Cu CMP, comprising an amino acid, a purine compound, an alcohol amine, a quaternary ammonium salt, and an antioxidant.

Additionally, as the semiconductor wafer process progresses, the width of the metal wire is narrowed to 14 nm, making planarization more difficult. For example, the surface of the wafer with a nano-width wire may be rougher after the process, and the result of the open/short test and reliability test of the copper wire wafer becomes worse after the wire width is narrowed. Therefore, it is important to develop a cleaning composition that is more effective than the prior art at removing residual contaminants on the copper wire wafer surface and reducing the surface defect count.

The subject invention is directed at the above demands by providing an aqueous cleaning composition for post copper chemical mechanical planarization that can effectively remove residual contaminants and reduce the defect count on the wafer surface, while simultaneously, impart the wafer with a better surface roughness.

### SUMMARY OF THE INVENTION

An objective of the subject invention is to provide an aqueous cleaning composition for post copper chemical-mechanical planarization (post-Cu CMP), comprising an organic base wherein the organic base is selected from the group consisting of tetramethylammonium hydroxide (TMAH), tetraethylammonium hydroxide (TEAH), tetrapropylammonium hydroxide (TPAH), tetrabutylammonium hydroxide (TBAH), tris(2-hydroxyethyl) methylammonium hydroxide (THEMAH), cetyltrimethylammonium hydroxide (CTAH), choline, and combinations thereof, and in a concentration of 400 ppm to 12,000 ppm, a copper etchant, wherein the copper etchant is an N-containing compound, which is selected from the group consisting of piperazine, 1-(2-aminoethyl)piperazine, 1-(2-hydroxyethyl)piperazine, 2-(1-piperazinyl)ethanol, 2-(1-piperazinyl)ethylamine, 2-(2-aminoethoxy)ethanol, 2-(2-aminoethylamino)ethanol, 2-amino-1-butanol, 2-amino-1-propanol, 2-aminoethanol, 2-dimethylaminoethanol, 2-(N-methylamino)ethanol, 3-amino-1-propanol, ethanolamine, diethanolamine, triethanolamine, diethylenetriamine, diisopropanolamine, isopropanolamine, N-methyldiethanolamine, N-methylethanolamine, diglycolamine (DGA), bicine, tricine, tris(hydroxymethyl)aminomethane (Tris), and combinations thereof, and in a concentration of 300 ppm to 10,000 ppm, an organic ligand, wherein the organic ligand is a phosphonic acid, wherein the phosphonic acid is selected from the group consisting of diethylenetriamine penta(methylene phosphonic acid) (DTPMP), 2-phosphonobutane-1,2,4-tricarboxylic acid (PBTCA), hexamethylenediamine tetra(methylene phosphonic acid) (HDTMP), 2-hydroxy phosphonoacetic acid (HPAA), 2-carboxyethyl phosphonic acid (CEPA), phosphino carboxylic acid polymer (PCA), polyamino polyether methylene phosphonic acid (PAPEMP), 2-aminoethylphosphonic acid (AEPn), N-(phosphonomethyl)iminodiacetic acid (PMIDA), amino tris(methylene phosphonic acid) (ATMP), and combinations thereof, a corrosion inhibitor, and water, wherein the corrosion inhibitor is a hydrazide compound and wherein the hydrazide compound is carbohydrazide; and wherein the organic ligand is in a concentration of 50 ppm to 10,000ppm; and the corrosion inhibitor is in a concentration of 10 ppm to 5,000 ppm, and wherein the pH value of the cleaning composition is above 9. Optionally, the aqueous cleaning composition may further comprise a surfactant.

To further illustrate the objective, technical features and advantages of the subject invention, the subject invention will be described in detail according to several embodiments.

### DESCRIPTION OF THE PREFERRED EMBODIMENT

Hereinafter, some embodiments of the subject invention will be described in detail. Furthermore, unless it is additionally explained, the expressions "a," "the," or the like in the specification of the subject invention (especially in the claims) should include both the singular and the plural forms.

The present inventors conducted research and found that combining an organic base, copper etchant, organic ligand, and corrosion inhibitor (hydrazide compound) in the post copper CMP cleaning procedure may obtain a desirable rate for removing contaminants, effectively reduce the defect count on the wafer surface, and impart the wafer with a better surface roughness.

Therefore, the subject invention provides an aqueous cleaning composition, comprising an organic base , wherein the organic base is selected from the group consisting of tetramethylammonium hydroxide (TMAH), tetraethylammonium hydroxide (TEAH), tetrapropylammonium hydroxide (TPAH), tetrabutylammonium hydroxide (TBAH), tris(2-hydroxyethyl) methylammonium hydroxide (THEMAH), cetyltrimethylammonium hydroxide (CTAH), choline, and combinations thereof, and in a concentration of 400 ppm to 12,000 ppm, a copper etchant, wherein the copper etchant is an N-containing compound, which is selected from the group consisting of piperazine, 1-(2-aminoethyl)piperazine, 1-(2-hydroxyethyl)piperazine, 2-(1-piperazinyl)ethanol, 2-(1-piperazinyl)ethylamine, 2-(2-aminoethoxy)ethanol, 2-(2-aminoethylamino)ethanol, 2-amino-1-butanol, 2-amino-1-propanol, 2-aminoethanol, 2-dimethylaminoethanol, 2-(N-methylamino)ethanol, 3-amino-1-propanol, ethanolamine, diethanolamine, triethanolamine, diethylenetriamine, diisopropanolamine, isopropanolamine, N-methyldiethanolamine, N-methylethanolamine, diglycolamine (DGA), bicine, tricine, tris(hydroxymethyl)aminomethane (Tris), and combinations thereof, and in a concentration of 300 ppm to 10,000 ppm, an organic ligand wherein the organic ligand is a phosphonic acid, wherein the phosphonic acid is selected from the group consisting of diethylenetriamine penta(methylene phosphonic acid) (DTPMP), 2-phosphonobutane-1,2,4-tricarboxylic acid (PBTCA), hexamethylenediamine tetra(methylene phosphonic acid) (HDTMP), 2-hydroxy phosphonoacetic acid (HPAA), 2-carboxyethyl phosphonic acid (CEPA), phosphino carboxylic acid polymer (PCA), polyamino polyether methylene phosphonic acid (PAPEMP), 2-aminoethylphosphonic acid (AEPn), N-(phosphonomethyl)iminodiacetic acid (PMIDA), amino tris(methylene phosphonic acid) (ATMP), and combinations thereof, a corrosion inhibitor, which is a hydrazide compound, and wherein the hydrazide compound is carbohydrazide; and water, wherein the organic ligand is in a concentration of 50 ppm to 10,000 ppm, and the corrosion inhibitor is in a concentration of 10 ppm to 5,000 ppm, and, wherein the pH value of the cleaning composition is above 9.

Without being limited by theory, it is generally believed that in the cleaning composition of the subject invention, the organic base that is used may adjust the basicity of the cleaning composition, ensuring that the abrasive particles used in the CMP process and the wafer surface maintain an effective negative electrostatic repulsion, thus, removing the abrasive particles well. Also, the organic base can provide a mild metal etching effect. In addition, for the copper process, the organic base is not subjected to a rough copper surface as encountered when using ammonia. The useful organic base is a quaternary ammonium selected from a group consisting of tetramethylammonium hydroxide (TMAH), tetraethylammonium hydroxide (TEAH), tetrapropylammonium hydroxide (TPAH), tetrabutylammonium hydroxide (TBAH), tris(2-hydroxyethyl) methylammonium hydroxide (THEMAH), cetyltrimethylammonium hydroxide (CTAH), choline, and combinations thereof. In the following working examples, the illustrated organic base is TMAH, TEAH, THEMAH, CTAH and choline.

In practical use of the aqueous cleaning composition of the subject invention, the organic base is generally in a concentration of 400 ppm to 12,000 ppm, and preferably 400 ppm to 6,000 ppm, to provide the effect of adjusting the basicity of the composition. However, to reduce the cost of manufacturing, transportation and storage, the manufacturer of the aqueous cleaning composition usually provides the composition as a concentrated solution. The user may dilute the concentrated solution to a desirable concentration. Therefore, the aqueous cleaning composition of the subject invention may be provided in a concentrated form and diluted to the desired concentration before use. The organic base in the aqueous cleaning composition of the subject invention is thus, in a concentration of at least 400 ppm.

The aqueous cleaning composition of the subject invention also uses a copper etchant, which is an N-containing compound such as a heterocyclic amine, an alcohol amine. Without being limited by theory, it is believed that when the heterocyclic amine is used, the unpaired electron pair of the nitrogen atom in the heterocyclic ring of the heterocyclic amine may form a coordinate covalent bond with a metal atom (such as copper), therefore, not only providing the desired effect of removing the abrasive particles, but also preventing the organic contaminants that have escaped from the metal wire from chemisorbing again. Moreover, when the alcohol amine is used, it also etches the metal surface evenly such that the roughness of the etched metal wire is not worsened. The copper etchant that is used in the subject invention is selected from a group consisting of piperazine, 1-(2-aminoethyl)piperazine, 1-(2-hydroxyethyl)piperazine, 2-(1-piperazinyl)ethanol, 2-(1-piperazinyl)ethylamine, 2-(2-aminoethoxy)ethanol, 2-(2-aminoethylamino)ethanol, 2-amino-1-butanol, 2-amino-1-propanol, 2-aminoethanol, 2-dimethylaminoethanol, 2-(N-methylamino)ethanol, 3-amino-1-propanol, ethanolamine, diethanolamine, triethanolamine, diethylenetriamine, diisopropanolamine, isopropanolamine, N-methyldiethanolamine, N-methylethanolamine, diglycolamine (DGA), bicine, tricine, tris(hydroxymethyl)aminomethane (Tris), and combinations thereof. In the following working examples, the illustrated copper etchant can be selected from piperazine, 2-(2-aminoethoxy)ethanol, 2-amino-1-butanol, 2-amino-1-propanol, 3-amino-1-propanol, ethanolamine, diethanolamine, triethanolamine, diethylenetriamine, N-methylethanolamine, bicine, and Tris.

The copper etchant in the aqueous cleaning composition of the subject invention in practical use is in a concentration of 300 ppm to 10,000 ppm, and preferably, 300 ppm to 5,000 ppm. As mentioned above, the aqueous cleaning composition of the subject invention may be provided in a concentrated form and diluted to the desired concentration before use. Therefore, the copper etchant contained in the aqueous cleaning composition of the subject invention is in a concentration of at least 300 ppm.

Moreover, the cleaning composition of the subject invention also comprises an organic ligand. The "organic ligand" herein means an organic substance(s) that may chemisorb or bond a residue such as BTA on the wafer after the CMP process. Without being limited by theory, it is generally believed that the organic ligand may increase the saturation solubility of organic substances such as BTA, and improve the cleaning effect. The organic ligand suitable for the cleaning composition of the subject invention is a phosphonic acid selected from a group consisting of diethylenetriamine penta(methylene phosphonic acid) (DTPMP), 2-phosphonobutane-1,2,4-tricarboxylic acid (PBTCA), hexamethylenediamine tetra(methylene phosphonic acid) (HDTMP), 2-hydroxy phosphonoacetic acid (HPAA), 2-carboxyethyl phosphonic acid (CEPA), phosphino carboxylic acid polymer (PCA), polyamino polyether methylene phosphonic acid (PAPEMP) 2-aminoethylphosphonic acid (AEPn) N-(phosphonomethyl)iminodiacetic acid (PMIDA), amino tris(methylene phosphonic acid) (ATMP), and combinations thereof. In practical use, the organic ligand contained in the aqueous cleaning composition of the subject invention is generally in a concentration of 50 ppm to 10,000 ppm and preferably 100 ppm to 5,000 ppm. As mentioned above, the aqueous cleaning composition of the subject invention may be provided in a concentrated form and diluted to the desired concentration before use. Therefore, the organic ligand in the aqueous cleaning composition of the subject invention is in a concentration of at least 50 ppm, and preferably, at least 100 ppm.

Another component useful in the composition of the subject invention is a corrosion inhibitor, a hydrazide compound. Carbohydrazide is used as the corrosion inhibitor in the composition of the subject invention.

Without being limited by theory, it is generally believed that the corrosion inhibitor, selected from a hydrazide compound, can protect the metal layer on the wafer surface and prevent the dissolution of the metal layer in the cleaning solution, thus, contributing to the reduction of the defect count on the wafer surface and maintaining a tolerable roughness.

In practical use, the hydrazide compound contained in the aqueous cleaning composition of the subject invention is generally in a concentration of 10 ppm to 5,000 ppm and preferably 50 ppm to 2,500 ppm. As mentioned above, the aqueous cleaning composition of the subject invention may be provided in a concentrated form and diluted to the desired concentration before use. Therefore, the hydrazide compound contained in the aqueous cleaning composition of the subject invention is in a concentration of at least 10 ppm, and preferably, at least 50 ppm.

In addition to the organic base, copper etchant, organic ligand, and corrosion inhibitor, the cleaning composition of subject invention may optionally further comprise a surfactant.

Without being limited by theory, it is generally believed that the surfactant can provide adequate wetting of the wafer surface during the cleaning. The surfactant that is used in the composition of the subject invention is an ethoxylated mercaptan represented by formula H(OCH₂CH₂)ₙSR₅, wherein R₅ is a hydrocarbyl group and n is 1 to 100. The "hydrocarbyl group" may be for example, but is not limited to, an alkyl group, an alkenyl group, an alkynyl group, a cycloalkyl group, an aryl group, an arylalkyl group and an alkaryl group; the aforementioned groups may be branched, linear, substituted or non-substituted. In the above formula, R₅ is preferably C₁ to C₃₀ alkyl, C₂ to C₃₀ alkenyl, C₂ to C₃₀ alkynyl, C₃ to C₃₀ cycloalkyl, C₅ to C₃₀ aryl, C₆ to C₃₀ arylalkyl or C₆ to C₃₀ alkaryl, and n is preferred to be from 4 to 20. More preferably, R₅ is C₆ to C₁₈ alkyl or C₆ to C₁₈ arylalkyl, and n is from 4 to 12.

The example of the surfactant suitable for the cleaning composition of the subject invention can be selected from a group consisting of ethoxylated tertiary dodecyl mercaptan, ethoxylated n-dodecyl mercaptan, ethoxylated 2-phenylethyl mercaptan, and combinations thereof, but is not limited thereto. Commercial available products of the surfactant suitable for the composition of the subject invention are such as Alcodet 260, Alcodet SK and Alcodet 218 from Shibley Chemicals (Elyria, OH). In the following working examples, the illustrated surfactant is Alcodet 218. The surfactant contained in the aqueous cleaning composition of the subject invention in practical use is generally in a concentration of 50 ppm to 3,000 ppm, and preferably, 100 ppm to 1,000 ppm.

Additionally, the pH value of the aqueous cleaning composition of the subject invention is above 9, and preferably above 10.

The cleaning composition of the subject invention may be used under room temperature. For example, the cleaning composition of the subject invention and the copper semiconductor wafer are brought into contact for a period of effective time to remove the contaminants on the surface of the wafer and maintain a desirable surface roughness of the copper wire. Generally, a longer contact time (1 to 3 minutes) is needed when the used concentration is lower, and a shorter contact time (less than 1 minute) is needed when the used concentration is higher. The user may adjust the time in practical use according to the necessity.

In the practice use of the aqueous cleaning composition of the subject invention, the cleaning composition of the subject invention may be used on the CMP platform to clean the planarized wafer surface, and may also be used on a separate cleaning platform to clean the planarized wafer surface.

The following examples further illustrate the subject invention .

### EXAMPLES

The organic ligands listed in Table 1 are mainly available from Shandong Taihe Water Treatment Co., Ltd (China), and other chemicals are available from Sigma-Aldrich, Alfa Aesar, MERCK, Showa Chemical, Tokyo Chemical Industrial (TCI) with a purity over 99%.

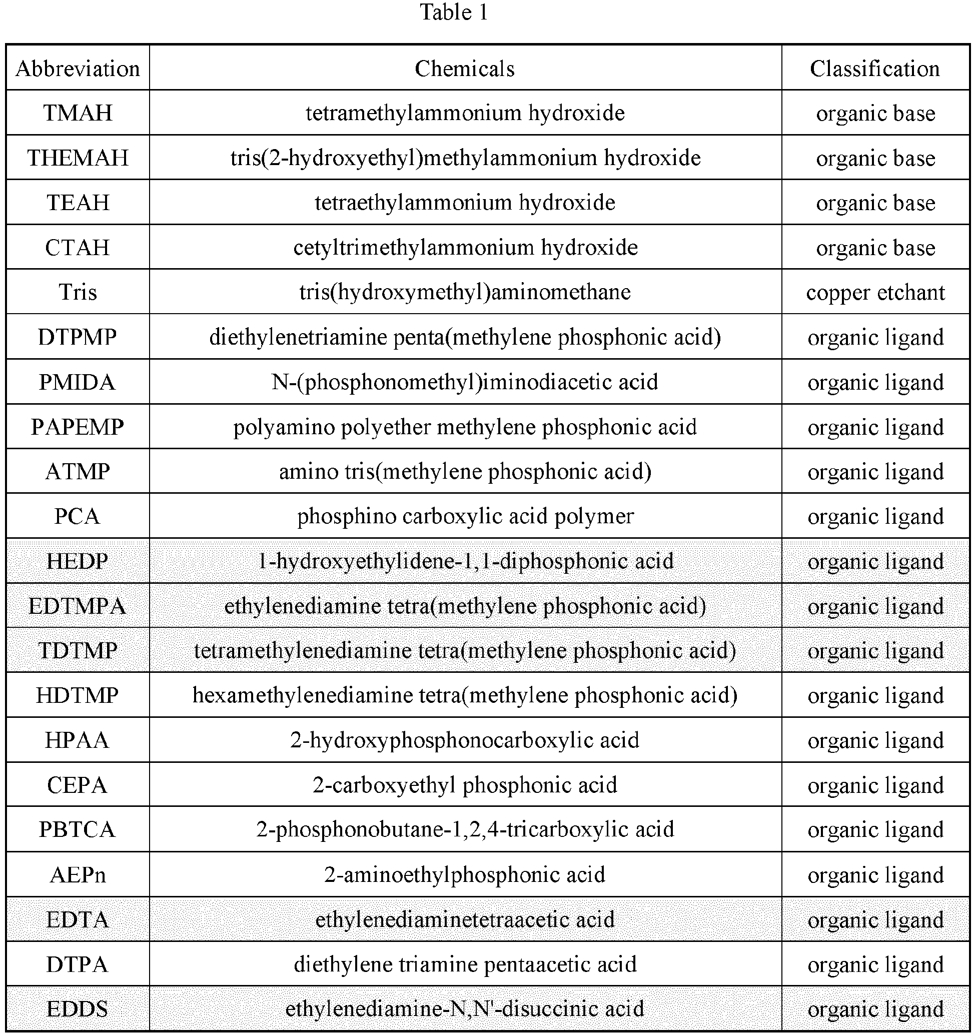

The surfactant Alcodet 218 is supplied by Rhodai (U.S.), which composition is ethoxylated dodecyl mercaptan (CAS. NO.: 9004-83-5).

The cleaning compositions were prepared according to the components and amounts listed in Table 2. In the examples, the blanket copper wafers were purchased from SKW Associates, Inc. (U.S) with a 1.5 µm thickness copper film. The blanket TEOS wafers were purchased from SVTC Technologies, L.L.C. (U.S.), with a 1.0 µm thickness film.

The blanket copper wafer was polished for 20 seconds using a C8908 copper slurry produced by Cabot Microelectronics Corporation (U.S.), then polished for 60 seconds using a B7601 barrier slurry produced by Cabot Microelectronics Corporation (U.S) to remove the copper film by a thickness of 0.2 µm. Then, the abrasive solution contaminated blanket copper wafer was placed on an OnTrak cleaning platform by Entrepix, Inc. (U.S.) and cleaned using the compositions listed in the following table. The blanket TEOS wafer was polished for 60 seconds using a B7601 barrier slurry produced by Cabot Microelectronics Corporation (U.S.) to remove the TEOS film by a thickness of 300 to 1000 Å. Then, the abrasive solution contaminated blanket TEOS wafer was placed on an OnTrak cleaning platform by Entrepix, Inc. (U.S.) and cleaned using the compositions listed in the following table. The cleaning time lasted 2 minutes with a flow rate of the cleaning composition of 1500 ml/min. After cleaning, the surface roughness was measured with atomic force microscopy (AFM), and the surface defect count was measured with KLA-Tencor SP1. The results are depicted in Table 2.

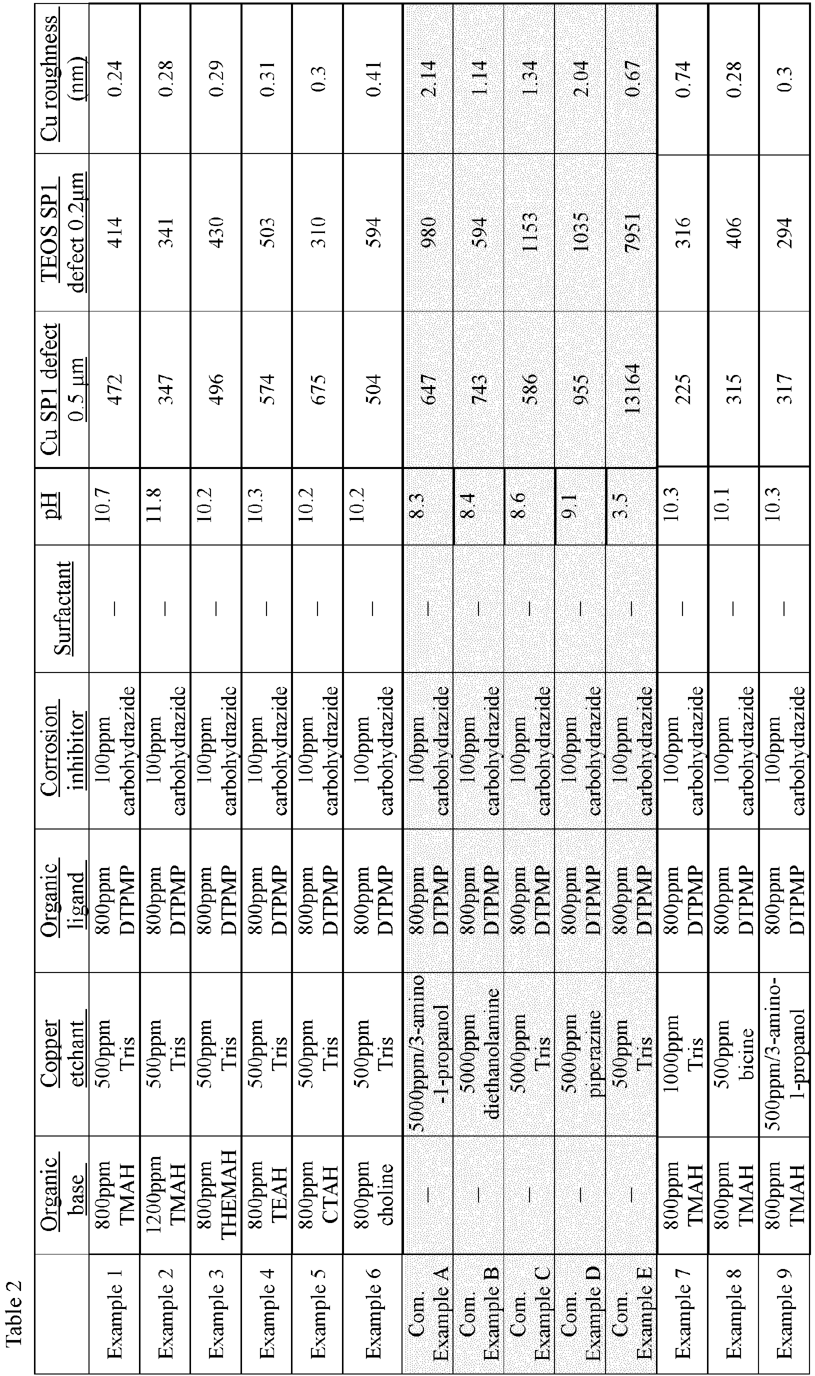

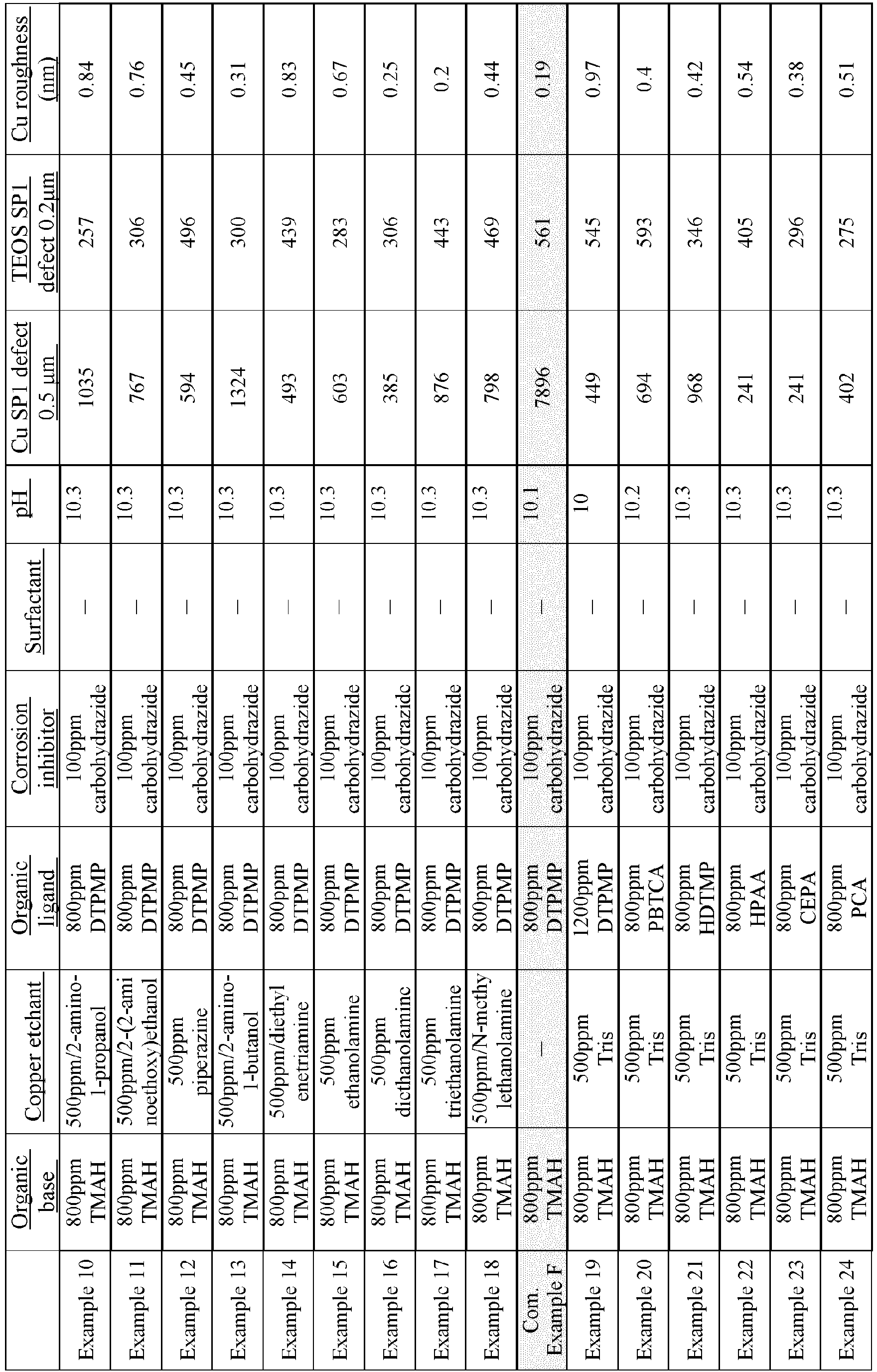

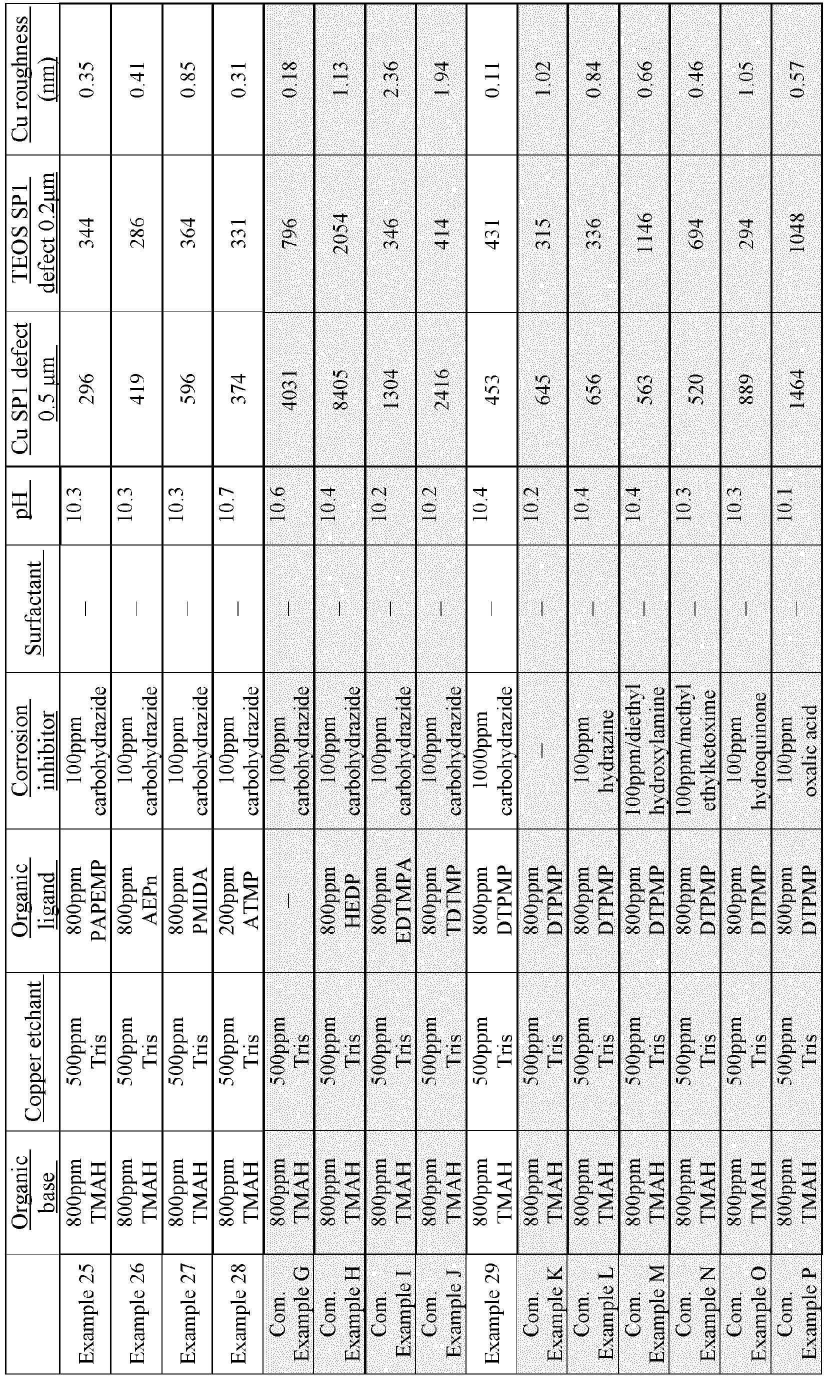

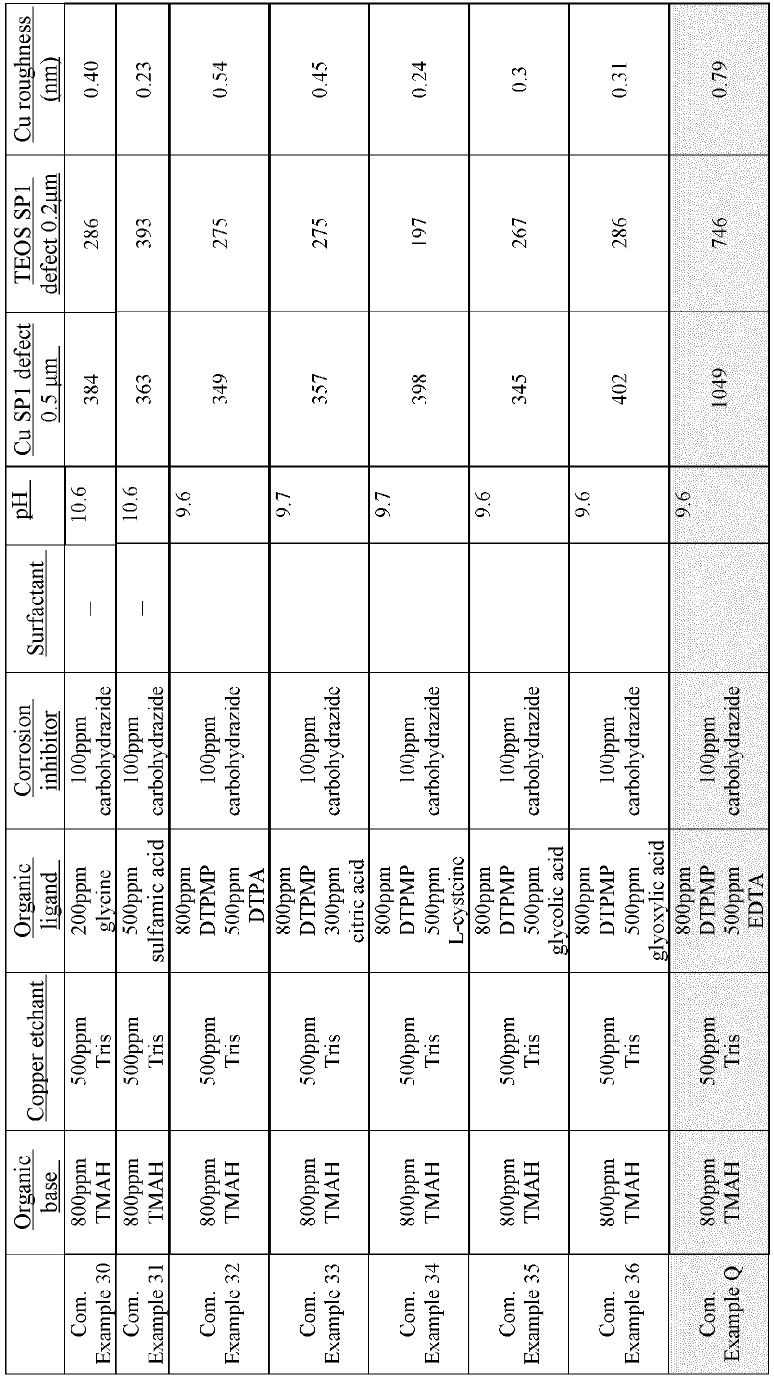

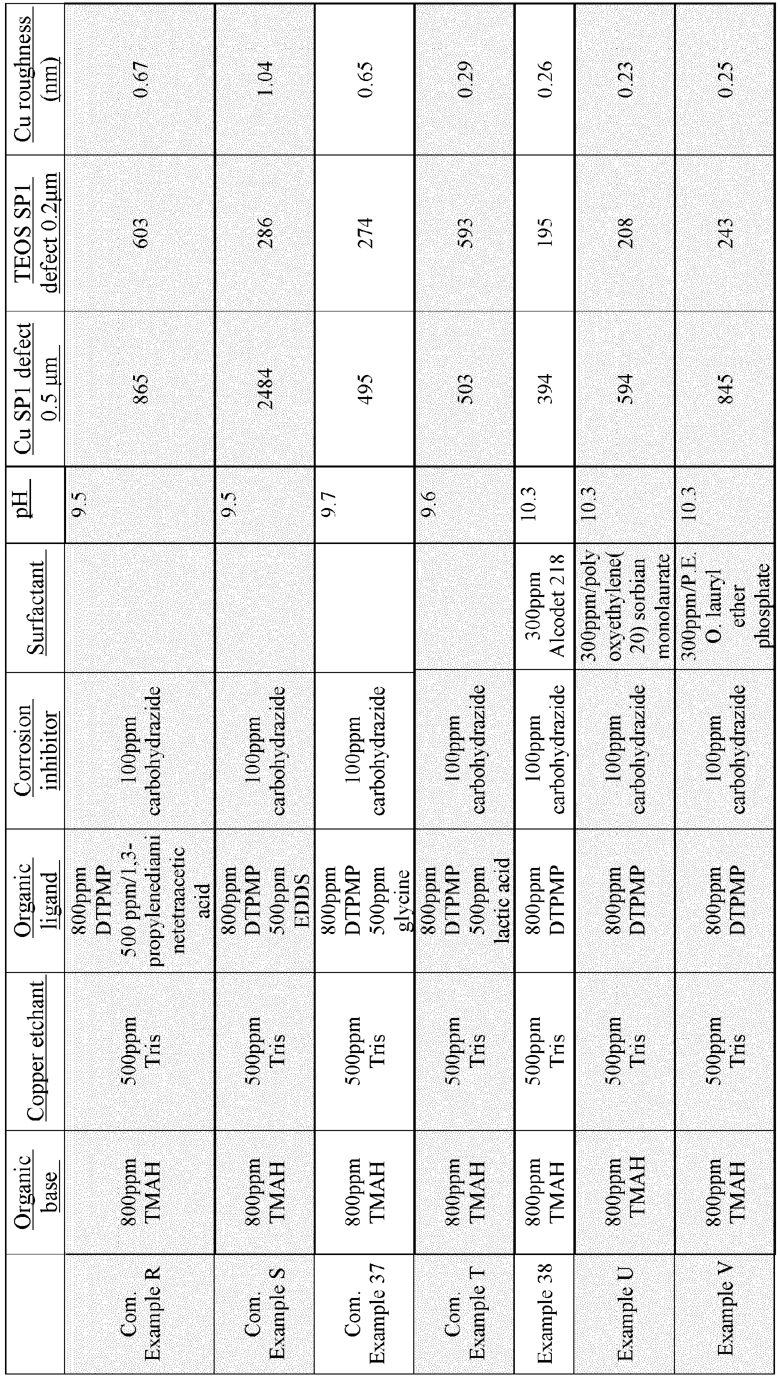

Table 2 shows that the compositions combining specific organic bases, copper etchants, organic ligands, and corrosion inhibitors (Examples 1 to 29 and Com. Examples 30 to 37) generally may more effectively eliminate the various defects than the compositions comprising other components (Com. Examples L to T) or the compositions without one certain component (Com. Examples A to G and K). Moreover, the addition of a certain surfactant may further reduce the copper wafer defect count (Example 38 and Examples U and V).

The above examples are used to illustrate the preferred embodiments of the subject invention, and are not intended to limit the subject invention, which is defined by the claims.

## Claims

1. An aqueous cleaning composition for post copper chemical-mechanical planarization (post-Cu CMP), comprising:
an organic base, wherein the organic base is selected from the group consisting of tetramethylammonium hydroxide (TMAH), tetraethylammonium hydroxide (TEAH), tetrapropylammonium hydroxide (TPAH), tetrabutylammonium hydroxide (TBAH), tris(2-hydroxyethyl) methylammonium hydroxide (THEMAH), cetyltrimethylammonium hydroxide (CTAH), choline, and combinations thereof, and in a concentration of 400 ppm to 12,000 ppm,
a copper etchant, wherein the copper etchant is an N-containing compound, which is selected from the group consisting of piperazine, 1-(2-aminoethyl)piperazine, 1-(2-hydroxyethyl)piperazine, 2-(1-piperazinyl)ethanol, 2-(1-piperazinyl)ethylamine, 2-(2-aminoethoxy)ethanol, 2-(2-aminoethylamino)ethanol, 2-amino-1-butanol, 2-amino-1-propanol, 2-aminoethanol, 2-dimethylaminoethanol, 2-(N-methylamino)ethanol, 3-amino-1-propanol, ethanolamine, diethanolamine, triethanolamine, diethylenetriamine, diisopropanolamine, isopropanolamine, N-methyldiethanolamine, N-methylethanolamine, diglycolamine (DGA), bicine, tricine, tris(hydroxymethyl)aminomethane (Tris), and combinations thereof, and in a concentration of 300 ppm to 10,000 ppm,
an organic ligand, wherein the organic ligand is a phosphonic acid, wherein the phosphonic acid is selected from the group consisting of diethylenetriamine penta(methylene phosphonic acid) (DTPMP), 2-phosphonobutane-1,2,4-tricarboxylic acid (PBTCA), hexamethylenediamine tetra(methylene phosphonic acid) (HDTMP), 2-hydroxy phosphonoacetic acid (HPAA), 2-carboxyethyl phosphonic acid (CEPA), phosphino carboxylic acid polymer (PCA), polyamino polyether methylene phosphonic acid (PAPEMP), 2-aminoethylphosphonic acid (AEPn), N-(phosphonomethyl)iminodiacetic acid (PMIDA), amino tris(methylene phosphonic acid) (ATMP), and combinations thereof,
a corrosion inhibitor, which is a hydrazide compound, and wherein the hydrazide compound is carbohydrazide; and
water,
wherein the organic ligand is in a concentration of 50 ppm to 10,000ppm, and the corrosion inhibitor is in a concentration of 10 ppm to 5,000 ppm, and
wherein the pH value of the cleaning composition is above 9.

2. The aqueous cleaning composition of claim 1, wherein the phosphonic acid is in a concentration of 100 ppm to 10,000ppm.

3. The aqueous cleaning composition of claim 1 or claim 2, further comprising a surfactant, which is an ethoxylated mercaptan represented by formula H(OCH₂CH₂)ₙSR₅, wherein R₅ is a hydrocarbyl group and n is 1 to 100, and the surfactant is in a concentration of at least 50 ppm.

4. The aqueous cleaning composition of claim 3, wherein the ethoxylated mercaptan is selected from a group consisting of ethoxylated tertiary dodecyl mercaptan, ethoxylated n-dodecyl mercaptan, ethoxylated 2-phenylethyl mercaptan, and combinations thereof, and in a concentration of at least 100 ppm.

## Patentansprüche

1. Wässrige Reinigungszusammensetzungen zur Post-Kupfer-Chemisch-Mechanischen Planarisierung (Post-Cu CMP), umfassend:
eine organische Base, wobei die organische Base ausgewählt ist aus der Gruppe bestehend aus Tetramethylammoniumhydroxid (TMAH), Tetraethylammoniumhydroxid (TEAH), Tetrapropylammoniumhydroxid (TPAH), Tetrabutylammoniumhydroxid (TBAH), Tris(2-hydroxyethyl)methylammoniumhydroxid (THEMAH), Cetyltrimethylammoniumhydroxid (CTAH), Cholin und Kombinationen davon, und in einer Konzentration von 400 ppm bis 12.000 ppm,
ein Kupferätzmittel, wobei das Kupferätzmittel eine N-enthaltende Verbindung ist, die ausgewählt ist aus der Gruppe bestehend aus Piperazin, 1-(2-Aminoethyl)piperazin, 1-(2-Hydroxyethyl)piperazin, 2-(1-Piperazinyl)ethanol, 2-(1-Piperazinyl)ethylamin, 2-(2-Aminoethoxy)ethanol, 2-(2-Aminoethylamino)ethanol, 2-Amino-1-butanol, 2-Amino-1-propanol, 2-Aminoethanol, 2-Dimethylaminoethanol, 2-(N-Methylamino)ethanol, 3-Amino-1-propanol, Ethanolamin, Diethanolamin, Triethanolamin, Diethylentriamin, Diisopropanolamin, Isopropanolamin, N-Methyldiethanolamin, N-Methylethanolamin, Diglycolamin (DGA), Bicin, Tricin, Tris(hydroxymethyl)aminomethan (Tris) und Kombinationen davon, und in einer Konzentration von 300 ppm bis 10.000 ppm,
einen organischen Liganden, wobei der organische Ligand eine Phosphonsäure ist, wobei die Phosphonsäure ausgewählt ist aus der Gruppe bestehend aus Diethylentriaminpenta(methylenphosphonsäure) (DTPMP), 2-Phosphonobutan-1,2,4-tricarbonsäure (PBTCA), Hexamethylendiamintetra(methylenphosphonsäure) (HDTMP), 2-Hydroxyphosphonoessigsäure (HPAA), 2-Carboxyethylphosphonsäure (CEPA), Phosphinocarbonsäure-Polymer (PCA), Polyaminopolyethermethylenphosphonsäure (PAPEMP), 2-Aminoethylphosphonsäure (AEPn), N-(Phosphonomethyl)iminodiessigsäure (PMIDA), Aminotris(methylenphosphonsäure) (ATMP) und Kombinationen davon,
einen Korrosionshemmer, der eine Hydrazidverbindung ist, und wobei die Hydrazidverbindung Carbohydrazid ist; und
Wasser,
wobei der organische Ligand in einer Konzentration von 50 ppm bis 10.000 ppm vorliegt und der Korrosionshemmer in einer Konzentration von 10 ppm bis 5.000 ppm vorliegt und
wobei der pH-Wert der Reinigungszusammensetzung größer als 9 ist.

2. Wässrige Reinigungszusammensetzung gemäß Anspruch 1, wobei die Phosphonsäure in einer Konzentration von 100 ppm bis 10.000 ppm vorliegt.

3. Wässrige Reinigungszusammensetzung gemäß Anspruch 1 oder Anspruch 2, ferner umfassend ein grenzflächenaktives Mittel, das ein ethoxyliertes Mercaptan ist, das durch die Formel H (OCH₂CH₂) ₙSR₅ dargestellt wird, wobei R₅ eine Hydrocarbylgruppe ist und n 1 bis 100 ist, und das grenzflächenaktive Mittel in einer Konzentration von wenigstens 50 ppm vorliegt.

4. Wässrige Reinigungszusammensetzung gemäß Anspruch 3, wobei das ethoxylierte Mercaptan ausgewählt ist aus einer Gruppe bestehend aus ethoxyliertem tertiärem Dodecylmercaptan, ethoxyliertem n-Dodecylmercaptan, ethoxyliertem 2-Phenylethylmercaptan und Kombinationen davon, und in einer Konzentration von wenigstens 100 ppm.

## Revendications

1. Composition aqueuse de nettoyage pour un post-aplanissement mécano-chimique de cuivre (post-AMC de Cu), comprenant :
une base organique, la base organique étant choisie dans le groupe constitué par l'hydroxyde de tétraméthylammonium (TMAH), l'hydroxyde de tétraéthylammonium (TEAH), l'hydroxyde de tétrapropylammonium (TPAH), l'hydroxyde de tétrabutylammonium (TBAH), l'hydroxyde de tris(2-hydroxyéthyl) méthylammonium (THEMAH), l'hydroxyde de cétyltriméthylammonium (CTAH), la choline, et des combinaisons correspondantes, et en une concentration de 400 ppm à 12 000 ppm,
un agent d'attaque du cuivre, l'agent d'attaque du cuivre étant un composé contenant N, qui est choisi dans le groupe constitué par la pipérazine, la 1-(2-aminoéthyl)pipérazine, la 1-(2-hydroxyéthyl)pipérazine, le 2-(1-pipérazinyl}éthanol, la 2-(1-pipérazinyl)éthylamine, le 2-(2-aminoéthoxy)éthanol, le 2-(2-aminoéthylamino)éthanol, le 2-amino-1-butanol, le 2-amino-1-propanol le 2-aminoéthanol, le 2-diméthylaminoéthanol, le 2-(N-méthylamino)éthanol, le 3-amino-1-propanol, l'éthanolamine, la diéthanolamine, la triéthanolamine, la diéthylènetriamine, la diisopropanolamine, l'isopropanolamine, la N-méthyldiéthanolamine, la N-méthyléthanolamine, la diglycolamine (DGA), la bicine, la tricine, le tris(hydroxyméthyl)aminométhane (Tris), et des combinaisons correspondantes, et en une concentration de 300 ppm à 10 000 ppm,
un ligand organique, le ligand organique étant un acide phosphonique, l'acide phosphonique étant choisi dans le groupe constitué par l'acide diéthylènetriamine penta(méthylène phosphonique) (DTPMP), l'acide 2-phosphonobutane-1,2,4-tricarboxylique (PBTCA), l'acide hexamethylènediamine tétra(méthylène phosphonique) (HDTMP), l'acide 2-hydroxyphosphonoacétique (HPAA), l'acide 2-carboxyéthylphosphonique (CEPA), un polymère d'acide phosphino carboxylique (PCA), un acide polyamino polyéther méthylène phosphonique (PAPEMP), l'acide 2-aminoéthylphosphonique (AEPn), l'acide N-(phosphonométhyl)iminodiacétique (PMIDA), l'acide amino tris(méthylène phosphonique) (ATMP), et des combinaisons correspondantes,
un inhibiteur de corrosion, qui est un composé de type hydrazide, et le composé de type hydrazide étant un carbohydrazide ; et
de l'eau,
le ligand organique étant présent en une concentration de 50 ppm à 10 000 ppm, et l'inhibiteur de corrosion étant présent en une concentration de 10 ppm à 5 000 ppm, et
la valeur de pH de la composition de nettoyage étant supérieure à 9.

2. Composition aqueuse de nettoyage selon la revendication 1, l'acide phosphonique étant présent en une concentration de 100 ppm à 10 000 ppm.

3. Composition aqueuse de nettoyage selon la revendication 1 ou la revendication 2, comprenant en outre un tensioactif, qui est un mercaptan éthoxylé représenté par la formule H (OCH₂CH₂) ₙSR₅, R₅ étant un groupe hydrocarbyle et n étant 1 à 100, et le tensioactif étant présent en une concentration d'au moins 50 ppm.

4. Composition aqueuse de nettoyage selon la revendication 3, le mercaptan éthoxylé étant choisi dans un groupe constitué par un dodécylmercaptan tertiaire éthoxylé, le n-dodécylmercaptan éthoxylé, le 2-phényléthylmercaptan éthoxylé, et des combinaisons correspondantes, et en une concentration d'au moins 100 ppm.
